# EUROPEAN PATENT APPLICATION

(11) **EP 4 701 362 A1**
(43) Date of publication of application: **25.02.2026**
(21) Application number: 25195729.6
(22) Date of filing: 13.08.2025
(51) Int. Cl.: H10D 12/01, H10D 8/00, H10D 12/00, H10D 62/10, H10D 62/13, H10D 84/00

(54) **REVERSE CONDUCTING IGBT WITH ELECTRON BARRIER LAYER BETWEEN THE CATHODE AND THE DRIFT REGION**

(30) Priority: 14.08.2024 US 202418804314
(71) Applicant: Littelfuse, Inc., Rosemont, Illinois 60018 (US)
(72) Inventor: Waind, Peter, Rosemont, 60018 (US)
(74) Representative: Arnold & Siedsma

(57) **Abstract**

An apparatus and an associated method for a reverse-conducting insulated gate bipolar transistors and associated structures. The apparatus includes a substrate (104) disposed between a frontside and a backside, a diode pilot region (114a) disposed in the substrate, an insulated gate bipolar transistor, IGBT, region (110) disposed in the substrate, and a diode region (106, 108) with a barrier layer (126) disposed laterally adjacent to each of and between the diode pilot region (114a) and the IGBT region (110). The barrier layer is a p-type lateral extension of the IGBT collector region, provided vertically between part of the cathode region (114b) of the diode and the drift region (104), and configured to prevent flow of electrons under specific operating conditions.

## Description

### TECHNICAL FIELD

This disclosure relates generally to the field of semiconductor devices, and in particular, to manufacturing of semiconductor devices, and even more particularly, to reverse conducting insulated-gate bipolar transistors.

### BACKGROUND

An insulated-gate bipolar transistor (IGBT) is a three-terminal power semiconductor device that acts as a highly efficient fast electronic switch. It includes four alternating layers (P-N-P-N) controlled using a metal-oxide-semiconductor (MOS) gate structure. In most applications, IGBTs are used together with a fast antiparallel diode to allow inductive load current to freewheel. In the case of reverse conducting IGBT (RC-IGBT), this diode is integrated into the IGBT structure. The usual operating states of RC-IGBT include forward conduction (ON-state of the IGBT mode), reverse conduction (ON-state of the diode mode), forward turning-ON (turning ON state of IGBT mode), forward turning-OFF (turning OFF state of the IGBT mode), and reverse recovery (reverse recovery state of the diode mode). However, existing RC-IGBT-based devices typically can suffer from snapback issues. While these can usually be solved by incorporating a separate diode pilot region into the structure, the addition of such pilot section(s) reduces uniformity of operation of the RC-IGBT and, thus, reduces the overall performance.

### SUMMARY

The following summary is provided to introduce a selection of concepts in a simplified form that are further described below in the detailed description. This summary is not intended to identify key or essential features of the claimed subject matter, nor is it intended as an aid in determining the scope of the claimed subject matter.

In some implementations, the current subject matter relates to a semiconductor apparatus. The apparatus may include a substrate disposed between a frontside and a backside, a diode pilot region disposed in the substrate, an insulated gate bipolar transistor (IGBT) region disposed in the substrate, and a diode region with a barrier layer disposed adjacent to each of and between the diode pilot region and the IGBT region. The barrier layer may be configured to prevent flow of electrons at a first predetermined current and allow flow of electrons at a second predetermined current.

In some implementations, the current subject matter relates to a method for manufacturing a semiconductor device. The method may include providing a substrate and forming at least one frontside structure and at least one backside structure on the substrate, forming a diode pilot region in the substrate, forming an insulated gate bipolar transistor (IGBT) region in the substrate, and forming a diode region with a barrier layer adjacent to each of and between the diode pilot region and the IGBT region. The barrier layer may be configured to prevent flow of electrons at a first predetermined current and allow flow of electrons at a second predetermined current. The method may also include forming a collector layer and a diode cathode layer in the substrate, which may include forming a first portion of the collector layer formed adjacent the IGBT region, forming a first portion of the diode cathode layer adjacent the diode pilot region, and forming a second portion of the collector layer and a second portion of the diode cathode layer under the diode region with the barrier layer, wherein the second portion of the collector layer is formed adjacent the second portion of the diode cathode layer. The method may also include forming a buffer layer above the diode cathode layer and the collector layer and adjacent the diode pilot region, the barrier layer and the IGBT region.

In some implementations, the current subject matter may include one or more optional features, as discussed herein.

The details of one or more variations of the subject matter described herein are set forth in the accompanying drawings and the description below. Other features and advantages of the subject matter described herein will be apparent from the description and drawings, and from the claims.

### BRIEF DESCRIPTION OF THE DRAWINGS

The accompanying drawings, which are incorporated in and constitute a part of this specification, show certain aspects of the subject matter disclosed herein and, together with the description, help explain some of the principles associated with the disclosed implementations. In the drawings,
FIG. 1A illustrates an example of a semiconductor apparatus, according to some implementations of the current subject matter;
FIG. 1B illustrates another example of a semiconductor apparatus, according to some implementations of the current subject matter;
FIG. 1C illustrates an example of an implementation of one or more backside diffusions, according to some implementations of the current subject matter and
FIG. 2 illustrates an example process for manufacturing a semiconductor device, such as a reverse-conducting insulated gate bipolar transistor (RC-IGBT), according to some implementations of the current subject matter.

### DETAILED DESCRIPTION

Various approaches in accordance with the present disclosure will now be described more fully hereinafter with reference to the accompanying drawings, where implementations of a system and method are shown. The devices, system(s), component(s), etc., may be embodied in many different forms and are not to be construed as being limited to the example implementations set forth herein. Instead, these example implementations are provided so this disclosure will be thorough and complete, and will fully convey the scope of the current subject matter to those skilled in the art.

To address these and potentially other deficiencies of currently available solutions, one or more implementations of the current subject matter relate to methods, systems, articles of manufacture, and the like that can, among other possible advantages, provide systems and methods for manufacturing semiconductor devices, and in particular, for manufacturing reverse conducting insulated-gate bipolar transistors (RC-IGBTs).

Reverse conducting insulated gate bipolar transistors (RC-IGBTs) are advanced power semiconductor devices that combine the attributes of both insulated gate bipolar transistors (IGBTs) and diodes on a single chip. As stated above, IGBT includes four alternating P, N layers controlled by MOS gate structure. An IGBT cell has a structure that is similar to an n-channel vertical-construction power MOSFET, however, the n+ drain is replaced with a p+ collector layer, thereby forming a vertical PNP bipolar junction transistor. The p+ region creates a cascade connection of a PNP bipolar junction transistor with the surface n-channel MOSFET. The IGBT structure is also similar to a MOS-gate thyristor, however, the thyristor action is suppressed, and only the transistor action is permitted in the entire device operation range. The IGBT is designed to synthesize complex waveforms with pulse-width modulation and low-pass filters and can be used in switching amplifiers (e.g., motor control, multi-level inverters, industrial control systems, etc.), and/or any other devices, systems, etc. The integration of IGBT and diodes allows for forward and reverse conduction, thereby making RC-IGBTs suitable for applications that may require bidirectional current flow (e.g., inverters for electric vehicles and/or industrial drives, etc.).

RC-IGBTs can handle various operating states, including forward conduction (IGBT mode), reverse conduction (diode mode), forward turning-on (turn-on mode), forward turning-off (turn-off mode), and diode reverse recovery (reverse recovery mode). In operation, RC-IGBT functions by controlling the flow of electrons and holes within its layered semiconductor structure. When a positive voltage is applied to the gate, it turns on the MOSFET component, allowing the collector voltage to drive the base current through the bipolar transistor. This, in turn, activates the bipolar transistor, permitting the load current to flow. This is referred to as the IGBT mode. When negative voltage is applied to the collector, the N-type layer acts as a diode cathode, and the p-type body diffusion of the MOSFET acts as a diode anode. This is referred as the diode mode, during which reverse conduction takes place.

Unlike power MOSFETs, the IGBT is not naturally reverse conducting due to the PN junction on the collector side. In the case of a MOSFET, the body diode can conduct uninhibited by a P-type diffusion on the back side. This means that in some IGBT applications, the IGBT can be used together with a separate fast recovery antiparallel diode, where the two chips often are assembled in the same package.

As stated above, in the RC-IGBT, the IGBT and diode are integrated into the same chip. This is achieved by the addition of N-type diffusion areas into the backside of the chip. These N+ areas then act as the cathode of diode regions. Elsewhere, the back side of the chip has a p-type diffusion functioning as the collector of the IGBT.

One of the advantages of the RC-IGBT is that only one chip type is needed to fulfill both functions of control of the forward current (IGBT section) and allow conduction of reverse current (diode section). This makes for a simpler and lower cost solution. Also, distribution of current is more uniform, in turn resulting in lower peak current densities and more uniform temperature distribution.

To achieve uniform current distribution, existing IGBT and diode sections are usually closely integrated across the active area of the chip. The IGBT and diode sections are not electrically isolated from each other and, consequently, there can be undesirable interaction between the regions during operation. In particular, during the IGBT conduction phase, some portion of the MOSFET electron current is diverted from the backside P-type collector regions to N-type cathode regions, which act as "shorts." When the IGBT section is in the fully ON-state, this loss of electron current to the cathode is of small consequence. However, at low currents, this diversion of electron current in conventional RC-IGBTs can delay injection of holes from the P-type IGBT collector suppressing IGBT action, resulting in a snapback characteristic in ON-state I-V curve. This is undesirable and can result in unstable sharing of current during the IGBT turn-on phase.

IGBT snapback refers to a sudden decrease in voltage across IGBT while conducting current, after initially withstanding a high voltage. This is similar to the snapback observed in thyristors and is characterized by a negative differential resistance region in the IGBT's output characteristics. During snapback, the IGBT transitions from a high-voltage, high-impedance state to a low-voltage, low-impedance state, which allows it to conduct large currents without sustaining high voltage drops. In some cases, the snapback (i.e., in the RC-IGBT current-voltage (I-V) curve) can occur from a small voltage (as opposed to a high voltage) and may result in non-uniform device turn-on.

To overcome this undesirable snapback characteristic, existing devices typically incorporate an "IGBT pilot" section into the RC-IGBT design. This is a region, or regions of, larger IGBT area, devoid of n-type collector. This section then exhibits smooth turn-on which spreads to the standard RC-IGBT regions. The overall RC-IGBT I-V curve now having a smooth characteristic. However, addition of the "pilot" section or sections, reduces uniformity of operation of the RC-IGBT. Even after full turn on the "pilot" section will run a higher current density as there are no N-type shorts there. This non-uniformity restricts the overall performance and rating of the conventional RC-IGBT.

To address these issues, in some implementations, the current subject matter relates to a semiconductor apparatus and methods of manufacture thereof. The semiconductor apparatus may incorporate an IGBT region, a diode pilot region and a diode region with electron barrier (hereinafter, referred to as "barrier region") disposed between the IGBT region and the diode pilot region. The barrier region may be an electron barrier region and may be configured to restrict collection of electrons by the N-type cathode areas of the semiconductor apparatus at low current, which may be helpful in reducing and/or preventing snap-back issues without the need for an IGBT pilot. The barrier region may be a P-type layer that may cover most of the N-type cathode regions. The regions may create a barrier to electrons at low IGBT currents. A small portion of each N-type cathode may be left open to allow for diode operation (otherwise, diode operation may be difficult to initiate upon reversal of the voltage). This portion is referred to here as the "diode pilot" region. The diode pilot regions may be made sufficiently small and remote from the IGBT region so that the IGBT region may be free from (and/or substantially free from) the snap-back issues. The hole barrier layer may be lightly doped such that it is effectively transparent to the flow of carriers at high current.

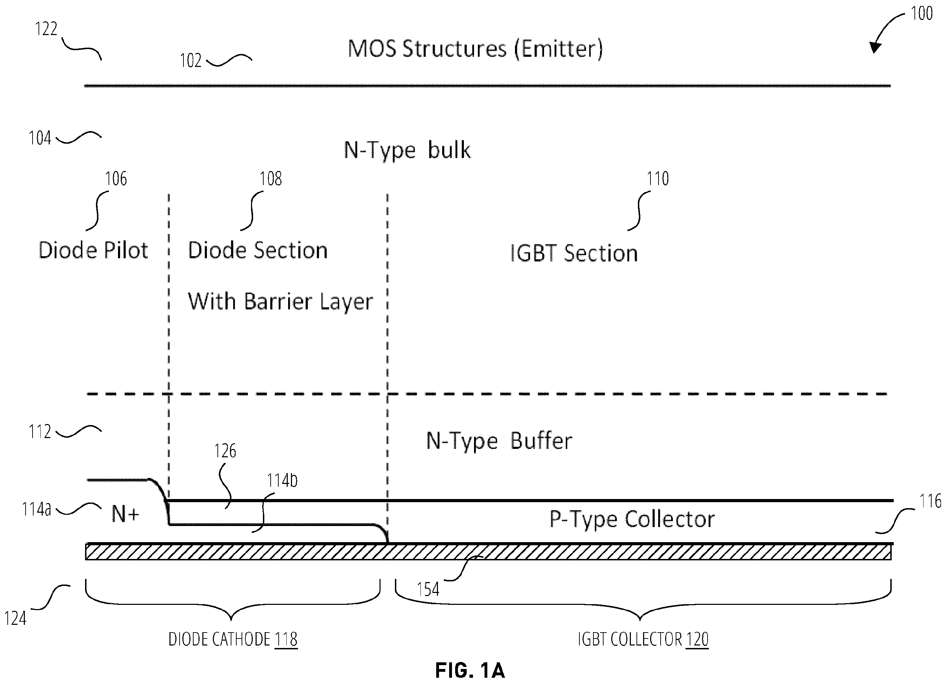

FIG. 1A illustrates an example of a semiconductor apparatus 100, according to some implementations of the current subject matter. The apparatus 100 may be structured as a reverse conducting insulated gate bipolar transistor (RC-IGBT) semiconductor device. The RC-IGBT apparatus 100 may include one or more MOS structure(s) 102, an N-type layer 104, a diode pilot region 106, a diode with barrier region 108, an IGBT region 110, an N-type buffer layer 112, a first N+ layer 114a, a second N+ layer 114b, a p-type barrier layer 126, a p-type collector layer 116, a diode cathode 118, an IGBT collector 120, and a contact metal layer 154 positioned on a backside 124 of the apparatus 100. The arrangement shown in FIG. 1A represents a section through a portion an active area of a semiconductor device. The active area may include one or more of such sections. Moreover, the active area may be terminated with one or more guard rings, JTE(s), etc. In some example, non-limiting implementations, the voltage rating of the apparatus 100 may be between 600 Volts to 6500 Volts.

The N-type layer 104 may be a substrate layer and/or a silicon wafer that may be disposed between a frontside 122 and a backside 124 of the apparatus 100. It may be configured to accommodate formation of one or more of the diode pilot region 106, diode with barrier region 108, IGBT region 110, N-type buffer layer 112, N+ layer 114a, N+ layer 114b, P-type barrier layer 126, and p-type collector 116 through various diffusion and/or any other semiconductor manufacturing techniques.

The MOS structure(s) 102 may represent frontside 122 of the RC-IGBT apparatus 100 and may be include an emitter of the apparatus 100, one or more gate contacts, an array of MOSFET structures in one or more active areas, which may include, but not limited to a trench, a planar, etc. with one or more varying geometries. The structure(s) 102 may also include one or more termination structures (e.g., guard rings, junction termination extension (JTE)). As can be understood, any other frontside components may be included in the MOS structure(s) 102.

The diode cathode 118 and the IGBT collector 120 (both of which may be and/or may form a continuous metal layer, rather than separate contacts) may be configured to be disposed in the backside 124 of the MOS structure(s) 102 and/or a substrate and/or a wafer. In particular, the backside 124 of the apparatus 100 may be arranged so as to align with appropriate frontside sections of the apparatus 100. The IGBT region 110 may be defined by a position of the diffusion of the collector 116. Diode region(s) may be similarly defined. While FIG. 1A schematically illustrates alignment of various regions, it is understood that no such requirement for alignment of the backside layers to the regions exists. In some implementations, the backside diffusions may be used to define the diode pilot region 106, the diode with barrier region 108, and the IGBT region 110, which may be positioned vis-à-vis respective active MOS structure(s) 102. As can be understood, the alignment illustrated in FIG. 1A may or may not be with specific MOSFET cells of MOS structure(s) 102. In some example, non-limiting implementations, the alignment may be used to provide more optimal performance of the semiconductor apparatus 100. The diode cathode 118 may be aligned with the regions 106 and 108, as shown in FIG. 1A. The regions may or may not be exactly aligned to the frontside 122 side pattern (i.e., the IGBT region 110, the diode with barrier region 108, and the diode pilot region 106).

Various options exist for implementing one or more backside 124 diffusions for the purposes of forming the above sections. For example, one option may be to perform a uniform P-type implantation and annealing to form the IGBT collector 120. Afterwards two higher concentration cathode masked implantations and annealing may be performed to form the diode-sections under the N+ layer 114a and N+ layer 114b: one may be deeper than the P-type layer, and one may be shallower. The shallower N+ cathode anneal may be controlled to leave a P-type barrier layer that may be configured to block electrons at a low current, but not at a high current. Moreover, different patterns may be used for the backside diffusions. For example, one pattern may include an array of circular diode areas with the diode pilot at the center of each. This geometry may allow the diode pilot to be remote from the IGBT, but with a minimum overall diode pilot area.

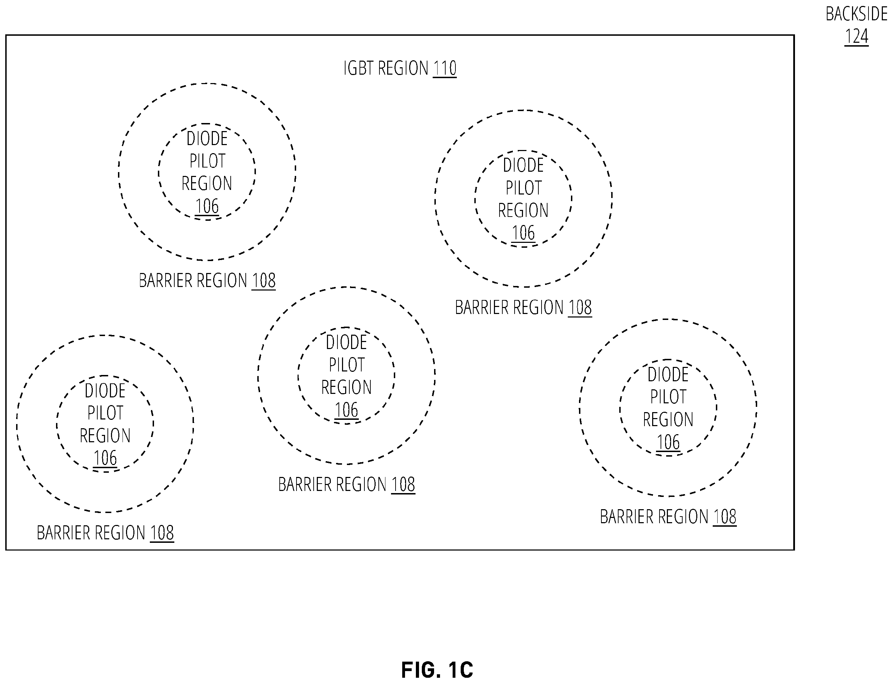

FIG. 1C illustrates an example of an implementation of one or more backside 124 diffusions, according to some implementations of the current subject matter. As shown in FIG. 1C, the IGBT region 110 may include one or more regions 108 and one or more diode pilot regions 106. The diffusions resulting in regions 106 and/or 108 may be disposed at any desired locations/positions in the backside 124. As can be understood, the current subject matter is not limited to the illustrated disposition of the regions 106 and/or 108 and any other ways of arranging backside 124 are possible.

As shown in FIG. 1A, the N-type layer 104 may be disposed and/or formed between the frontside 122, as represented by the MOS structure(s) 102, and the backside 124, as represented by the diode cathode 118 and the IGBT collector 120. Alternatively, or in addition, the N-type layer 104 may be provided as well as various layers, regions, etc., including the frontside 122 and/or backside 124 may be formed in it and/or on it. As can be understood, any order of formation of various layers, regions, etc. of the apparatus 100 is possible.

The N-type layer 104 may include the diode pilot region 106, the diode with barrier region 108, and the IGBT region 110. Each of these regions may be substantially vertically formed (fully and/or at least partially) between the frontside 122 and the backside 124 of the apparatus 100. The diode with barrier region 108 may be disposed between the diode pilot region 106 and the IGBT region 110.

The diode pilot region 106 may be disposed remote from the IGBT region 110. It may be used to perform diode operations of the RC-IGBT apparatus 100. In the RC-IGBT, the diode pilot region 106 may be forward biased and allow flow of diode current when a reverse bias is applied. The diode pilot region 106's unidirectional behavior is due to its diode's like structure (e.g., a p-n junction) that facilitates flow of electrons from the n-type material to the p-type material when forward-biased. In reverse bias, the junction prevents current flow, except for a minimal leakage. The diode pilot region 106 may be designed to be sufficiently small and/or remote from the IGBT region 110, so as to keep the IGBT region 110 substantially free from snapbacks.

In some implementations, the diode with barrier region 108 may be configured to be disposed across (and/or cover) substantially one or more of the cathode regions, e.g., the N+ layer 114b. The diode with barrier region 108 may include a P-type electron barrier layer 126 disposed above the N+ layer 114b. It may serve as a barrier to movement of electrons at low currents occurring in the IGBT region 110. The diode barrier region 126 may be lightly doped such that it may be configured to be substantially "transparent" to flow of carriers at high currents (e.g., doping of the diode with barrier region 108 may be such that it allows the uniformity of high diode current operation across both the diode pilot region 106 and the diode with barrier region 108). In some implementations, the open diode pilot area may be configured to be sufficiently large to avoid snapback in the diode conduction I-V curve, while being configured to be sufficiently small to avoid snapback in the IGBT conduction I-V curve (or keep the snapback to a minimum). Advantageously, the barrier region 126 may be configured to prevent latch up issues of the apparatus 100.

The N-type buffer layer 112 may be disposed between the backside 124 (in particular, the p-type collector 116, N+ layer 114a and N+ layer 114b) and the regions 106-110. The N-type buffer layer 112 may be disposed above the p-type collector 116, the N+ layer 114a, and the N+ layer 114b. The layer 112 may be configured to protect the IGBT collector 120 during an OFF state by preventing penetration of the electric field. It may also serve to reduce overall width of the RC-IGBT apparatus 100. In some example implementations, the N-type buffer layer 112 may be formed across all regions 106-110, as shown in FIG. 1A. Alternatively, or in addition, the N-type buffer layer 112 may be formed across some and/or portions of one or more regions 106-110. Further, in some example, non-limiting implementations, the N-type buffer layer 112 may have a substantially uniform width across the apparatus 100, i.e., underneath the regions 106-110. Alternatively, or in addition, the layer 112 may have a substantially uniform width underneath the diode with barrier region 108 and the IGBT region 110 and have a smaller width underneath the diode pilot region 106. Smaller width of the N-type buffer layer 112 underneath the diode pilot region 106 may allow for a larger N+ layer 114a as compared to the N+ layer 114b. This may allow for the diode operation to occur upon reversal of voltage across the apparatus 100. In some example, non-limiting implementations, the buffer layer 112 may be optional, e.g., it may be removed. In this case, the width of the apparatus 100 may be configured to be made greater to, for example, avoid penetration of electric field to the IGBT collector layer 116.

The p-type collector 116 may be disposed and/or formed (e.g., through P-diffusion in the N-type layer 104) underneath the N-type buffer layer 112 and above the contacts 118 and 120 disposed in the backside 124 of the RC-IGBT apparatus 100. At least one portion of the p-type collector 116 may be disposed across the IGBT collector 120 and p-type barrier layer 126 of the p-type collector 116 may be disposed in the diode with barrier region 108 and above the N+ layer 114b, which is part of the diode cathode 118. In some example, non-limiting implementation, as, for instance, is shown in FIG. 1A, the apparatus 100 may be configured to include the p-type barrier layer 126 that may be made uniform across the wafer backside, where in the IGBT section it may be as diffused, and in the diode with barrier region, it may be partially over-doped with a shallower N+ layer 114b, thereby leaving a thin p-type barrier layer 126, whereas, in the pilot section, it may be completely over-doped with a deeper N+ layer 114a.

The diode cathode layer (formed above diode cathode 118), as represented by the N+ layer 114a and N+ layer 114b, may be an N+-layer that may be formed underneath the diode pilot region 106 and the diode with barrier region 108. To allow for the diode operations, the N+ layer 114a may be formed to be wider than the N+ layer 114b. In particular, the wider (and/or thicker and/or deeper) portion of the diode cathode layer - the N+ layer 114a, may be formed underneath the diode pilot region 106. The narrower portion of the diode cathode layer - the N+ layer 114b, may be formed underneath the p-type barrier layer 126. The arrangement of the p-type barrier layer 126 and the N+ layer 114b may be configured to block electrons at low current but allow them at higher currents. The N+ layer 114a may, in some case, be made wider/thicker/deeper to provide complete over-doping of the p-type barrier layer 126.

The structural composition of the RC-IGBT apparatus 100 has numerous technical benefits over existing solutions. In particular, due to the inclusion of the diode with barrier region 108 between the diode pilot region 106 and the IGBT region 110, the RC-IGBT apparatus 100 may be configured to substantially eliminate IGBT snapback (i.e., sudden decrease in voltage across IGBT while conducting high current, after initially withstanding a high voltage). Further, the RC-IGBT apparatus 100 does not require an IGBT pilot region that is typically present in conventional semiconductor devices. Additionally, use of the region 108 ensures a smoother integration of the diode portion and the IGBT portion of the apparatus 100. The structural composition of the apparatus 100 may provide a more uniform IGBT current as well as thermal distribution during operation.

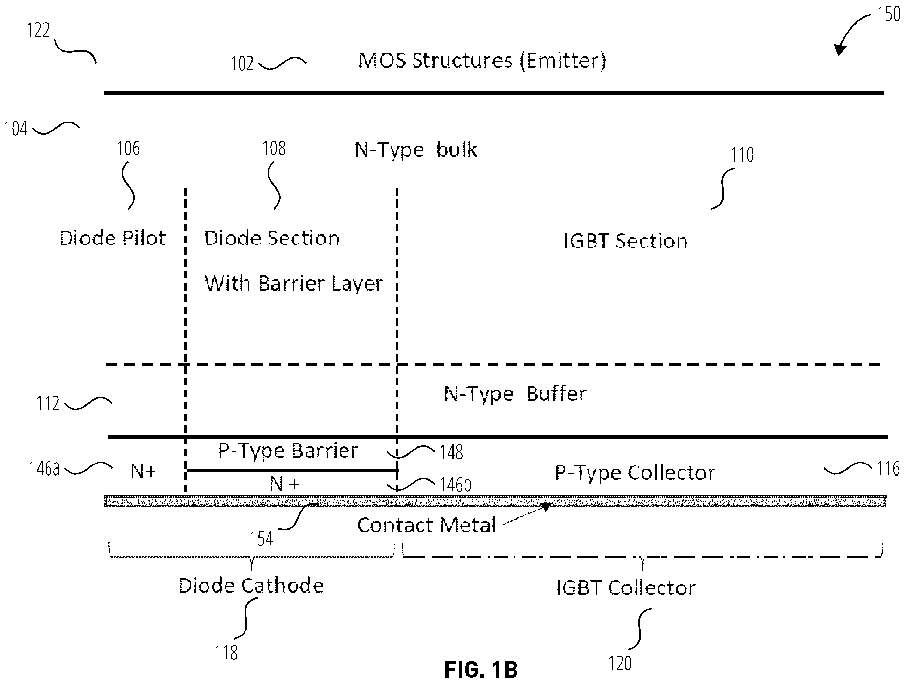

FIG. 1B illustrates another semiconductor apparatus 150, according to some implementations of the current subject matter. The apparatus 150 may be structured as an RC-IGBT semiconductor apparatus, similar to the semiconductor apparatus 100 shown in FIG. 1A. Similar to the apparatus 100, the apparatus 150 may include one or more MOS structure(s) 102, the N-type layer 104, the diode pilot region 106, the diode with barrier region 108, the IGBT region 110, N-type buffer layer 112, the p-type collector 116, the diode cathode 118, and the IGBT collector 120. Additionally, the device 150 may be configured to include a first N+ layer 146a, a second N+ layer 146b, a p-type barrier layer 148, and a contact metal layer 154. In addition to accommodating formation of the layers of the apparatus 150, the N-type layer 104 may also be configured to accommodate formation of the N+ layer 146a, N+ layer 146b, and P-type barrier layer 148 through various diffusion and/or any other semiconductor manufacturing techniques. The contact metal layer 154 may be positioned on the backside layer 104. The voltage rating of the apparatus 150 may be similar to that of apparatus 100 shown in FIG. 1A.

As shown in FIG. 1B, the N+ layer 146a may be disposed in the diode pilot region 106 and a depth/width/thickness that may be substantially equal to that of the P-type collector layer 116. The P-type barrier layer 148 may be disposed above the N+ layer 146b, where a combined depth/width/thickness of the P-type barrier layer 148 and the N+ layer 146b may be substantially equal to that of the P-type collector layer 116. As can be understood, these layers may have their own depth/width/thickness and do not necessarily have to be equal.

As with the apparatus 100 shown in FIG. 1A, the diode portion of the apparatus 150 may be composed of two regions - the diode pilot region 106 and the diode with barrier region 108. The diode pilot region 106 may be configured to initiate current flow, and the diode with barrier region 108 (which may include the P-type barrier 148 and the N+ layer 146b) may initiate operation when a predetermined current level (which may be defined in accordance with desired operational characteristics of the apparatus 150) is reached. In some implementations, the predetermined current level may also depend on the width/thickness/depth of the diode pilot region 106 and diode with barrier region 108. In some example, non-limiting implementation, concentration of the N-type buffer layer 112 may also affect the predetermined current level. Use of the predetermined current level for operation of the apparatus 150 (as well as apparatus 100 shown in FIG. 1A) may be configured to avoid snapback (or a small snapback) on the diode I-V curve of the apparatus 150 (and/or apparatus 100 shown in FIG. 1A).

In some example, implementations, the p-type barrier layer 148 may also affect the predetermined current level and thus, operation of the apparatus 150. If the layer 148 is too wide/deep/thick and/or highly doped, then the predetermined current level may be too high, thereby preventing the layer 148 from being a barrier to electrons during operation of the apparatus 150. Higher width/depth/thickness and/or doping of the layer 148 may also trigger latch-ups. FIGS. 1A and 1B illustrate some examples of configurations of the semiconductor apparatus that includes a diode with barrier region (e.g., region 108). As can be understood, any other configurations of the semiconductor apparatus are possible.

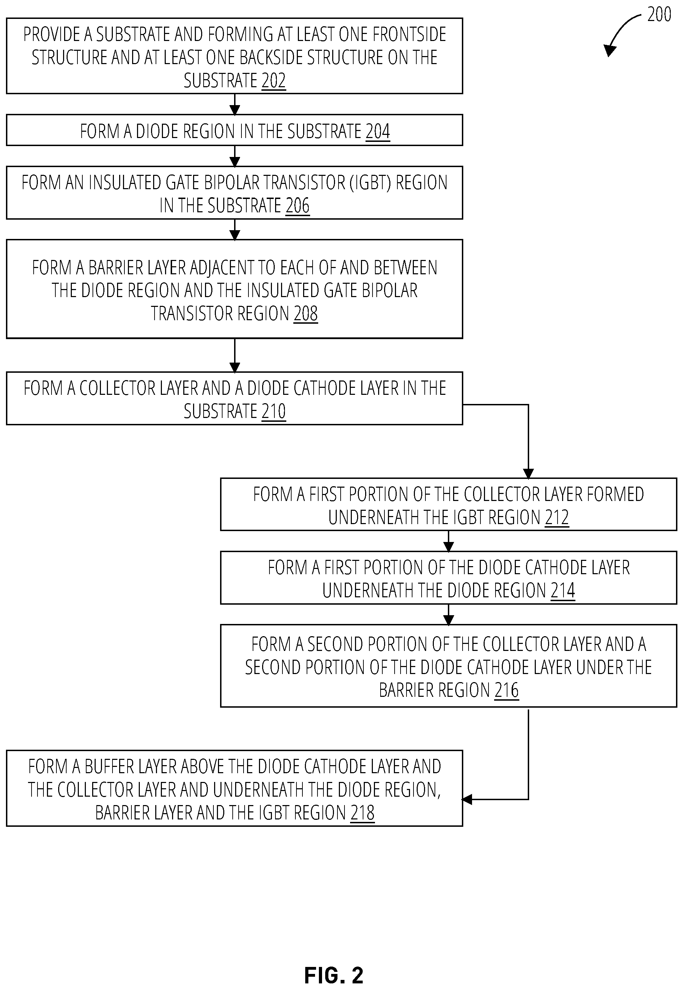

FIG. 2 illustrates an example process 200 for manufacturing a semiconductor device, such as a reverse-conducting insulated gate bipolar transistor (RC-IGBT), according to some implementations of the current subject matter. The process 200 may be used to manufacture the RC-IGBT apparatus 100 shown in FIG. 1A. As can be understood, the operations of the process 200 may be executed in any desired order, where one or more of the operations may be optional.

At 202, a substrate (e.g., N-type layer 104) may be provided. One or more frontside structures (e.g., frontside 122) and/or backside structures (e.g., backside 124) may be formed in and/or on the substrate. The frontside may include one or more metal-oxide semiconductor field effect transistor (MOSFET) structures. One or more MOSFET structures may include at least one of the following: an emitter, a gate, a gate oxide, a trench structure, a planar structure, an active structure, a termination, a guard ring, a junction termination extension, and any combination thereof. The backside may include a collector and/or a diode cathode. The collector may be disposed adjacent the diode cathode.

At 204, a diode region (e.g., diode pilot region 106) may be formed in the substrate.

At 206, an insulated gate bipolar transistor (IGBT) region (e.g., IGBT region 110) may be formed in the substrate.

At 208, a barrier layer (e.g., diode with barrier region 108) may be formed adjacent to each of and between the diode pilot region (e.g., diode pilot region 106) and the insulated gate bipolar transistor region (e.g., IGBT region 110). The barrier layer 126 may be configured to prevent flow of electrons at a first predetermined current (e.g., low IGBT current) and allow flow of electrons at a second predetermined current (e.g., high IGBT current). The barrier layer may be a p-type layer. Advantageously, the barrier layer may be configured to prevent latch-up.

At 210, a collector layer (e.g., p-type collector 116) and a diode cathode layer (e.g., as represented by N+ layer 114a and N+ layer 114b) may be formed in the substrate. Formation of the collector and diode cathode layers may include one or more of the following. At 212, a first portion of the collector layer may be formed underneath the IGBT region. At 214, a first portion (e.g., N+ layer 114a) of the diode cathode layer may be formed underneath the diode region (e.g., diode pilot region 106). At 216, a second portion (e.g., p-type barrier layer 126) of the collector layer and a second portion (e.g., N+ layer 114b) of the diode cathode layer may be formed adjacent (e.g., as shown in FIGS. 1A-B, under) the barrier region (e.g., diode with barrier region 108). The second portion of the collector layer (e.g., p-type barrier layer 126) may be formed adjacent (e.g., as shown in FIGS. 1A-B, above) the second portion (e.g., N+ layer 114b) of the diode cathode layer. Moreover, the first portion of the collector layer may be disposed adjacent (e.g., as shown in FIGS. 1A-B, above) the collector and the first portion of the diode cathode layer may be disposed adjacent (e.g., as shown in FIGS. 1A-B, above) the diode cathode. The collector layer may be a p-type collector layer and the diode cathode layer may be a N+-type diode cathode layer.

At 218, a buffer layer (e.g., N-type buffer layer 112) may be formed above the diode cathode layer (e.g., p-type collector 116) and the collector layer (e.g., N+ layer 114a and N+ layer 114b) and underneath the diode region, barrier layer and the IGBT region.

The components and features of the devices described above may be implemented using any combination of discrete circuitry, application specific integrated circuits (ASICs), logic gates and/or single chip architectures. Further, the features of the devices may be implemented using microcontrollers, programmable logic arrays and/or microprocessors or any combination of the foregoing where suitably appropriate. It is noted that hardware, firmware and/or software elements may be collectively or individually referred to herein as "logic" or "circuit."

It will be appreciated that the exemplary devices shown in the block diagrams described above may represent one functionally descriptive example of many potential implementations. Accordingly, division, omission or inclusion of block functions depicted in the accompanying figures does not infer that the hardware components, circuits, software and/or elements for implementing these functions would necessarily be divided, omitted, or included in embodiments.

Some embodiments may be described using the expression "one embodiment" or "an embodiment" or "an implementation" or "some implementations" along with their derivatives. These terms mean that a particular feature, structure, or characteristic described in connection with the embodiment is included in at least one embodiment. The appearances of the phrase "in one embodiment" (or derivatives thereof) in various places in the specification are not necessarily all referring to the same embodiment. Moreover, unless otherwise noted the features described above are recognized to be usable together in any combination. Thus, any features discussed separately may be employed in combination with each other unless it is noted that the features are incompatible with each other.

It is emphasized that the abstract of the disclosure is provided to allow a reader to quickly ascertain the nature of the technical disclosure. It is submitted with the understanding that it will not be used to interpret or limit the scope or meaning of the claims. In addition, in the foregoing detailed description, it can be seen that various features are grouped together in a single embodiment for the purpose of streamlining the disclosure. This method of disclosure is not to be interpreted as reflecting an intention that the claimed embodiments require more features than are expressly recited in each claim. Rather, as the following claims reflect, inventive subject matter lies in less than all features of a single disclosed embodiment. Thus, the following claims are hereby incorporated into the detailed description, with each claim standing on its own as a separate embodiment. In the appended claims, the terms "including" and "in which" are used as the plain-English equivalents of the respective terms "comprising" and "wherein," respectively. Moreover, the terms "first," "second," "third," and so forth, are used merely as labels, and are not intended to impose numerical requirements on their objects. Further, the use of "including," "comprising," or "having" and variations thereof herein is meant to encompass the items listed thereafter and equivalents thereof as well as additional items. Accordingly, the terms "including," "comprising," or "having" and variations thereof are open-ended expressions and can be used interchangeably herein.

For the sake of convenience and clarity, terms such as "top", "bottom", "upper", "lower", "vertical", "horizontal", "lateral", "transverse", "radial", "inner", "outer", "left", and "right" may be used herein to describe the relative placement and orientation of the features and components, each with respect to the geometry and orientation of other features and components appearing in the perspective, exploded perspective, and cross-sectional views provided herein. Said terminology is not intended to be limiting and includes the words specifically mentioned, derivatives therein, and words of similar import.

What has been described above includes examples of the disclosed architecture. It is, of course, not possible to describe every conceivable combination of components and/or methodologies, but one of ordinary skill in the art may recognize that many further combinations and permutations are possible. Accordingly, the novel architecture is intended to embrace all such alterations, modifications and variations that fall within the spirit and scope of the appended claims.

In one aspect, a semiconductor apparatus may include a substrate disposed between a frontside and a backside; a diode pilot region disposed in the substrate; an insulated gate bipolar transistor (IGBT) region disposed in the substrate; and a diode region with a barrier layer disposed adjacent to each of and between the diode pilot region and the IGBT region, wherein the barrier layer is configured to prevent flow of electrons at a first predetermined current and allow flow of electrons at a second predetermined current.

The barrier layer may be a p-type layer.

The first predetermined current may be a low IGBT current.

The second predetermined current may be a high IGBT current.

At least one of the first and second predetermined currents may be a diode current.

The frontside may include one or more metal-oxide semiconductor field effect transistor (MOSFET) structures.

The one or more MOSFET structures may include at least one of the following: an emitter, a gate, a gate oxide, a trench structure, a planar structure, an active structure, a termination, a guard ring, a junction termination extension, and any combination thereof.

The backside may include a collector and a diode cathode.

The collector may be disposed adjacent the diode cathode.

The apparatus may include a collector layer and a diode cathode layer, wherein a first portion of the collector layer may be disposed adjacent the collector and a first portion of the diode cathode layer may be disposed adjacent the diode cathode.

The collector layer and the diode cathode layer may be coupled using a contact metal layer.

The collector layer may be a p-type collector layer.

The diode cathode layer may be an N+-type diode cathode layer.

The first portion of the collector layer may be disposed adjacent the IGBT region.

The first portion of the diode cathode layer may be disposed adjacent the diode region.

A second portion of the collector layer and a second portion of the diode cathode layer may be disposed adjacent the diode region with the barrier layer.

The barrier layer may be formed in the collector layer.

The barrier layer may be separate from the collector layer.

The second portion of the collector layer may be disposed adjacent the second portion of the diode cathode layer.

The apparatus may include a buffer layer disposed above the diode cathode layer and the collector layer and underneath the substrate.

The semiconductor apparatus may be a reverse conducting insulated gate bipolar transistor.

In one aspect, a method for manufacturing a semiconductor device may include providing a substrate and forming at least one frontside structure and at least one backside structure on the substrate; forming a diode pilot region in the substrate; forming an insulated gate bipolar transistor (IGBT) region in the substrate; forming a diode region with a barrier layer adjacent to each of and between the diode pilot region and the IGBT region, wherein the barrier layer is configured to prevent flow of electrons at a first predetermined current and allow flow of electrons at a second predetermined current; forming a collector layer and a diode cathode layer in the substrate, the forming including forming a first portion of the collector layer formed adjacent the IGBT region, forming a first portion of the diode cathode layer adjacent the diode pilot region, and forming a second portion of the collector layer and a second portion of the diode cathode layer under the diode region with the barrier layer, wherein the second portion of the collector layer is formed adjacent the second portion of the diode cathode layer; and forming a buffer layer above the diode cathode layer and the collector layer and adjacent the diode pilot region, the barrier layer and the IGBT region.

The foregoing description of example embodiments has been presented for the purposes of illustration and description. It is not intended to be exhaustive or to limit the present disclosure to the precise forms disclosed. Many modifications and variations are possible in light of this disclosure. It is intended that the scope of the present disclosure be limited not by this detailed description, but rather by the claims appended hereto. Future filed applications claiming priority to this application may claim the disclosed subject matter in a different manner and may generally include any set of one or more limitations as variously disclosed or otherwise demonstrated herein.

All directional references (e.g., proximal, distal, upper, lower, upward, downward, left, right, lateral, longitudinal, front, back, top, bottom, above, below, vertical, horizontal, radial, axial, clockwise, and counterclockwise) are just used for identification purposes to aid the reader's understanding of the present disclosure, and do not create limitations, particularly as to the position, orientation, or use of this disclosure. Connection references (e.g., attached, coupled, connected, and joined) are to be construed broadly and may include intermediate members between a collection of elements and relative movement between elements unless otherwise indicated. As such, connection references do not necessarily infer that two elements are directly connected and in fixed relation to each other.

Further, identification references (e.g., primary, secondary, first, second, third, fourth, etc.) are not intended to connote importance or priority but are used to distinguish one feature from another. The drawings are for purposes of illustration only and the dimensions, positions, order and relative sizes reflected in the drawings attached hereto may vary.

The present disclosure is not to be limited in scope by the specific implementations described herein. Indeed, other various implementations of and modifications to the present disclosure, in addition to those described herein, will be apparent to those of ordinary skill in the art from the foregoing description and accompanying drawings. Thus, such other implementations and modifications are intended to fall within the scope of the present disclosure. Furthermore, the present disclosure has been described herein in the context of a particular implementation in a particular environment for a particular purpose. Those of ordinary skill in the art will recognize the usefulness is not limited thereto and the present disclosure may be beneficially implemented in any number of environments for any number of purposes.

## Claims

1. A semiconductor apparatus, comprising:
a substrate disposed between a frontside and a backside;
a diode pilot region disposed in the substrate;
an insulated gate bipolar transistor (IGBT) region disposed in the substrate; and
a diode region with a barrier layer disposed adjacent to each of and between the diode pilot region and the IGBT region, wherein the barrier layer is configured to prevent flow of electrons at a first predetermined current and allow flow of electrons at a second predetermined current.

2. The apparatus of claim 1, wherein the barrier layer is a p-type layer.

3. The apparatus of claim 1 or 2, wherein:
the first predetermined current is a low IGBT current, and/or
the second predetermined current is a high IGBT current,
preferably wherein at least one of the first and second predetermined currents is a diode current.

4. The apparatus of any one of the preceding claims, wherein the frontside includes one or more metal-oxide semiconductor field effect transistor (MOSFET) structures, preferably wherein the one or more MOSFET structures include at least one of the following: an emitter, a gate, a gate oxide, a trench structure, a planar structure, an active structure, a termination, a guard ring, a junction termination extension, and any combination thereof.

5. The apparatus of any one of the preceding claims, wherein the backside includes a collector and a diode cathode.

6. The apparatus of claim 5, wherein the collector is disposed adjacent the diode cathode.

7. The apparatus of claim 6, further comprising a collector layer and a diode cathode layer, wherein a first portion of the collector layer is disposed adjacent the collector and a first portion of the diode cathode layer is disposed adjacent the diode cathode.

8. The apparatus of claim 7, wherein:
the collector layer and the diode cathode layer are coupled using a contact metal layer; and/or
the collector layer is a p-type collector layer; and/or
the diode cathode layer is a N+-type diode cathode layer.

9. The apparatus of claim 7 or 8, wherein the first portion of the collector layer is disposed adjacent the IGBT region.

10. The apparatus of claim 9, wherein the first portion of the diode cathode layer is disposed adjacent the diode region.

11. The apparatus of claim 10, wherein a second portion of the collector layer and a second portion of the diode cathode layer are disposed adjacent the diode region with the barrier layer.

12. The apparatus of claim 11, wherein:
the barrier layer is formed in the collector layer; and/or
the barrier layer is separate from the collector layer; and/or
the second portion of the collector layer is disposed adjacent the second portion of the diode cathode layer.

13. The apparatus of any one of claims 7-12, further comprising a buffer layer disposed above the diode cathode layer and the collector layer and underneath the substrate.

14. The apparatus of any one of the preceding claims, wherein the semiconductor apparatus is a reverse conducting insulated gate bipolar transistor.

15. A method for manufacturing a semiconductor device, comprising:
providing a substrate and forming at least one frontside structure and at least one backside structure on the substrate;
forming a diode pilot region in the substrate;
forming an insulated gate bipolar transistor (IGBT) region in the substrate;
forming a diode region with a barrier layer adjacent to each of and between the diode pilot region and the IGBT region, wherein the barrier layer is configured to prevent flow of electrons at a first predetermined current and allow flow of electrons at a second predetermined current;
forming a collector layer and a diode cathode layer in the substrate, the forming including
forming a first portion of the collector layer formed adjacent the IGBT region, forming a first portion of the diode cathode layer adjacent the diode pilot region, and
forming a second portion of the collector layer and a second portion of the diode cathode layer under the diode region with the barrier layer, wherein the second portion of the collector layer is formed adjacent the second portion of the diode cathode layer;
and
forming a buffer layer above the diode cathode layer and the collector layer and adjacent the diode pilot region, the barrier layer and the IGBT region.
